# EUROPEAN PATENT APPLICATION

(11) **EP 2 914 063 A1**
(43) Date of publication of application: **02.09.2015**
(21) Application number: 13851899.8
(22) Date of filing: 01.10.2013
(51) Int. Cl.: H05B 33/04, H01L 51/50, H05B 33/06, H05B 33/10

(54) **ORGANIC ELECTROLUMINESCENCE LIGHT EMISSION DEVICE AND METHOD FOR MANUFACTURING SAME**

(30) Priority: 29.10.2012 JP 2012237857
(71) Applicant: Nitto Denko Corporation, Ibaraki-shi, Osaka 567-8680 (JP)
(72) Inventor: YOSHIKAWA, Jin, Ibaraki-shi Osaka 567-8680 (JP); OSAKI, Yoshinori, Ibaraki-shi Osaka 567-8680 (JP); NAKAI, Takahiro, Ibaraki-shi Osaka 567-8680 (JP)
(74) Representative: Grünecker Patent- und Rechtsanwälte PartG mbB
(86) International application number: PCT/JP2013/076690
(87) International publication number: WO 2014/069144

(57) **Abstract**

An organic EL device whose organic EL elements hardly deteriorate and the organic EL device manufacturing method are provided. The organic EL device 1 of the present invention includes: a light emission panel 2 and a sealing member 3, wherein the light emission panel 2 comprises a base material 21, a plurality of organic electroluminescence elements 5 each including an organic layer 53 and electrode terminals 521, 541, and a connection portion 6, wherein the organic electroluminescence elements 5 are disposed on the base material 21 in parallel in a tile pattern, and the connection portion 6 is a portion to which the electrode terminals 521, 541 of each organic electroluminescence element 5 are electrically connected; and the sealing member 3 seals a light emission region 22 formed by a plurality of organic layers 53 and an inter-layer region 23 sandwiched by two neighboring organic layers 53 in the light emission panel 2.

## Description

### TECHNICAL FIELD

The present invention relates to an organic electroluminescence (EL) device in which a plurality of electroluminescence elements is disposed in parallel in a tile pattern, and an organic electroluminescence device manufacturing method.

### BACKGROUND ART

Conventionally, forming a light emission panel of a large area by disposing a plurality of electroluminescence elements in parallel in a tile pattern, and forming a large organic electroluminescence device as a whole by electrically connecting a plurality of electroluminescence elements in the light emission panel are known (e.g. Patent Document 1). Hereinafter, the organic electroluminescence is simply referred as an "organic EL".

A material which is more likely to deteriorate due to contact with an outdoor air (mainly oxygen or water vapor) is generally used as a material for forming an organic EL element. In particular, an organic layer included in an organic EL element is likely to deteriorate due to contact with an outdoor air.

More specifically, an organic material included in the organic layer included in the organic EL element is likely to degenerate due to oxygen or water vapor contained in the outdoor air. When an organic material included in an organic layer degenerates, brightness of an organic EL element lowers, and the organic EL element does not stably emit a beam for a long period of time.

A large organic EL device in particular uses a plurality of organic EL elements, and therefore needs to more stably keep brightness of each organic EL element included in the organic EL device.

Hence, providing a sealing layer having a gas barrier property, at an outer side of an organic EL element to prevent brightness of the organic EL element from lowering is known (e.g. Patent Document 2). According to Patent Document 2, a sealing layer 4 (an oxygen barrier layer 42 and an oxygen absorption layer 41) which covers the outer side of an organic layer made of an organic light emission material 14 is provided. The sealing layer 4 covers the entirety of the organic EL elements except a substrate 11. According to Patent Document 2, a photocurable/thermosetting resin containing an inorganic composition is used for the sealing layer 4.

However, the above-described large organic EL device needs to electrically connect electrode terminals (portions from which an anode layer and a cathode layer are exposed) of neighboring organic EL elements in a light emission panel. Hence, when the electrode terminals of an individual organic EL element are covered by the sealing layer, the respective organic EL elements cannot be electrically connected. Therefore, a large organic EL device cannot be formed using a plurality of organic EL elements whose electrode terminals are covered by a sealing layer.

Further, an organic layer of an organic EL element which does not include a sealing layer contacts an outdoor air, and therefore the organic EL element is likely to deteriorate. Hence, a large organic EL device cannot be formed using organic EL elements which do not include a sealing layer.

Further, manufacturing a large organic EL device by using organic EL elements which are partially provided with a sealing layer except for electrode terminals is also conceived. However, portions of the organic EL elements at which electrode terminals are provided are very narrow. Hence, it is very complicated and difficult to provide a sealing layer to a portion of each organic EL element which does not include an electrode terminal. Hence, even when a sealing layer is provided to a portion except an electrode terminal of each organic EL element, there may be cases where the electrode terminal is covered by a sealing layer or an organic layer is exposed to the contrary. Therefore, organic EL elements whose electrode terminals are covered by a sealing layer cannot be electrically connected, and a large organic EL device cannot be formed. Further, when the organic layer is exposed, the organic EL element deteriorates.

[Patent Document 1] JP 2009-88515 A
[Patent Document 2] JP H07-169567 A

### SUMMARY OF INVENTION

An object of the present invention is to provide an organic EL device whose organic EL elements hardly deteriorate and a method for manufacturing the organic EL device.

An organic electroluminescence device includes: a light emission panel and a sealing member, wherein the light emission panel includes a base material, a plurality of organic electroluminescence elements each including an organic layer and electrode terminals, and a connection portion, wherein the organic electroluminescence elements are disposed on the base material in parallel in a tile pattern, and the connection portion is a portion to which the electrode terminals of each organic electroluminescence element are electrically connected; and the sealing member seals a light emission region formed by a plurality of organic layers and an inter-layer region sandwiched by two neighboring organic layers in the light emission panel.

According to the preferable organic EL device of the present invention, the electrode terminals include an anode terminal and a cathode terminal, and the connection portion includes a connector member provided across an anode terminal and a cathode terminal of two neighboring organic EL elements in the light emission panel, the sealing member inclusively seals the connection portion. Furthermore, the connector member is provided at one side portion of the light emission panel.

According to the preferable organic EL device of the present invention, a connection substrate including the connector member and a substrate on a surface of which the connector member is provided is connected to anode terminals and cathode terminals of the plurality of organic EL elements in the light emission panel to electrically connect each of the organic EL elements.

The connection substrate further includes a connection circuit which connects the organic EL elements in the light emission panel, to an external power supply, and the connection circuit, and an anode terminal and a cathode terminal of organic EL elements positioned at both ends of the light emission panel are electrically connected.

According to the preferable organic EL device of the present invention, the sealing member includes a sidewall portion which surrounds at least the light emission region and the inter-layer region, and a ceiling portion which covers the light emission region and the inter-layer region. A sealing space is formed between the sealing member and the light emission panel, and at least one of a desiccant and an oxygen absorber is filled in the sealing space.

Furthermore, the sealing member is a continuous resin layer which covers without a gap at least the light emission region and the inter-layer region.

According to the preferable organic EL device of the present invention, each organic EL element in the light emission panel further includes a barrier layer which prevents an outdoor air from entering.

According to another aspect of the present invention, a method for manufacturing an organic EL device is provided.

The method for manufacturing an organic EL device of the present invention includes: a light emission panel forming step and a sealing step, wherein the light emission panel forming step includes a disposing step of disposing a plurality of organic EL elements each including an organic layer and electrode terminals, on a base material in parallel in a tile pattern, and a connecting step of electrically connecting the electrode terminals of each organic EL element to form a connection portion; and the sealing step is a step of inclusively sealing, using a sealing member, a light emission region formed by a plurality of organic layers, and an inter-layer region sandwiched by two neighboring organic layers in the light emission panel.

According to the preferable method for manufacturing organic EL device of the present invention, the electrode terminals include an anode terminal and a cathode terminal, and the connection step is a step of electrically connecting an anode terminal and a cathode terminal of two neighboring organic EL elements in the light emission panel using a connector member to form a connection portion. The sealing step is a step of further inclusively sealing the connection portion.

According to the preferable method for manufacturing organic EL device of the present invention, the connection step is a step of connecting a connection substrate including the connector member and a substrate on a surface of which the connector member is provided, to anode terminals and cathode terminals of the plurality of organic EL elements in the light emission panel to electrically connect each of the organic EL elements and form a connection portion.

According to the present invention, it is possible to provide an organic EL device whose organic EL elements hardly deteriorate.

### BRIEF DESCRIPTION OF DRAWINGS

Fig. 1 is a schematic plan view illustrating an organic EL device according to one embodiment of the present invention.
Fig. 2 is an end view illustrating the organic EL device cut at a line II-II in Fig. 1.
Figs. 3A and 3B are schematic plan views illustrating correspondence relationships between two neighboring organic EL elements.
Fig. 4 is a schematic plan view illustrating an organic EL device according to a first modified example of the present invention.
Fig. 5 is an end view illustrating the organic EL device cut at a line V-V in Fig. 4.
Fig. 6 is an end view illustrating an organic EL device according to a second modified example of the present invention.
Fig. 7 is an end view illustrating an organic EL device according to a third modified example of the present invention.
Fig. 8 is a schematic back view illustrating one embodiment of a connection substrate used in the present invention.
Fig. 9 is a schematic plan view illustrating a state where the connection substrate is connected to a plurality of organic EL elements in Fig. 8.
Fig. 10 is a schematic plan view illustrating an organic EL device according to a fourth modified example of the present invention in which a sealing member is provided to a connection substrate and a plurality of organic EL elements in Fig. 9.
Fig. 11 is an end view illustrating the organic EL device cut at a line XI-XI in Fig. 10.
Fig. 12 is a schematic plan view illustrating one embodiment of the organic EL element used in the present invention.
Fig. 13 is an end view illustrating the organic EL element cut at a line XIII-XIII in Fig. 12.

### DESCRIPTION OF EMBODIMENTS

Hereinafter, the present invention will be described with reference to the drawings. It should be noted that dimensions such as a layer thickness and a length in the drawings are different from actual dimensions. In this specification, the terms "first" and "second" may be added as prefixes. These prefixes, however, are only added in order to distinguish the terms and do not have specific meaning such as order and relative merits.

Further, in this specification, a direction in which organic EL elements are disposed in parallel refers to a direction A, and a direction which is nearly orthogonal to the direction A refers to a direction B.

### [Organic EL Element]

A basic configuration of an organic EL element used in the present invention will be described before a configuration of an organic EL device according to the present invention will be described.

The organic EL element used in the present invention includes an element substrate and an organic EL layer stacked on the element substrate.

The organic EL layer includes a first electrode layer stacked on the element substrate, an organic layer stacked on the first electrode layer and a second electrode layer stacked on the organic layer.

In the present invention, a layer configuration of the organic EL element is not limited in particular as long as the above-described conditions are satisfied, and arbitrary layers can be added. Further, the organic EL element may be a top-emission element which can extract a beam from a surface side of an element substrate (a side on which the organic EL layer is stacked) or may be a bottom-emission element which can extract a beam from a back side of the element substrate.

Furthermore, the organic EL element used in the present invention includes electrode terminals (an anode terminal and a cathode terminal) which can distribute power to the first and second electrode layers.

When the first electrode layer is the anode layer, the electrode terminal which can distribute power to the first electrode layer is the anode terminal, and, when the second electrode layer is the cathode layer, the electrode terminal which can distribute power to the second electrode layer is the cathode terminal.

The shape of the organic EL element seen from a plan view is not limited in particular, an organic EL element whose shape is nearly rectangular seen from a plan view is generally used and an organic EL element whose shape is nearly belt-like seen from a plan view is preferably used.

By using organic EL elements whose shapes are nearly belt-like seen from a plan view, it is possible to dispose a plurality of organic EL elements in parallel in a width direction of the organic EL elements and form a large organic EL device.

The dimension of the organic EL element whose shape is nearly belt-like seen from a plan view is not limited in particular, and a width:length of the organic EL element is generally 1:3 to 1:20 and is preferably 1:3 to 1:10.

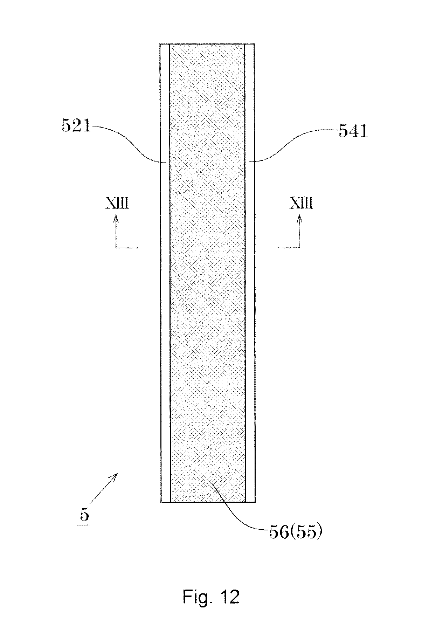

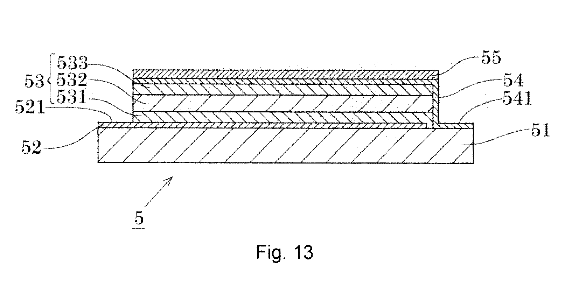

Figs. 12 and 13 illustrate examples of an organic EL element 5 used in the present invention.

The organic EL element 5 used in the present invention is preferably provided with electrode terminals (an anode terminal 521 and a cathode terminal 541) at both end portions in width direction of the organic EL element 5. In Fig. 12, the left end portion in width direction is the anode terminal 521, and the right end portion in width direction is the cathode terminal 541. In this case, as illustrated in Fig. 13, a first electrode layer 52 stacked on an element substrate 51 is an anode layer, and a second electrode layer 54 provided on an organic layer 53 is a cathode layer. In this regard, the anode layer and the cathode layer may be reversed. A portion to which a grid pattern is applied in Fig. 12 is a surface region 56 corresponding to the organic layer 53 of the organic EL element.

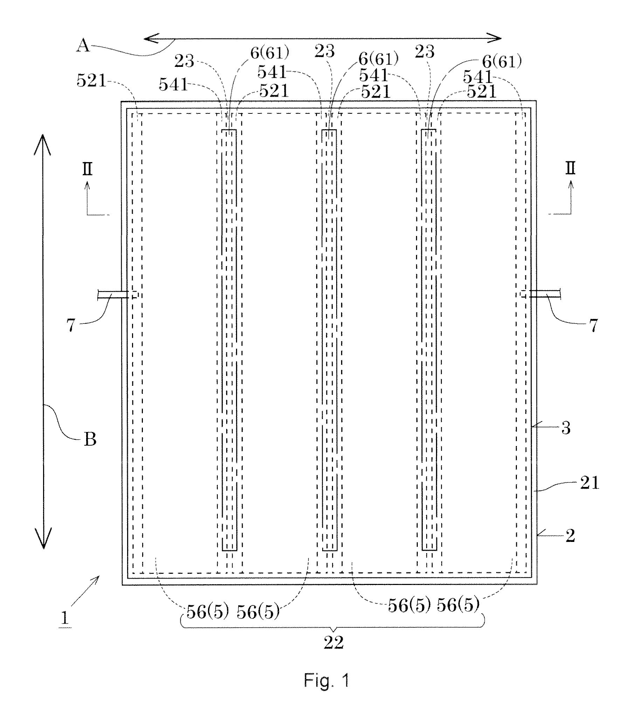

The configuration of the organic EL device will be described below. However, the organic EL element 5 used in Figs. 1, 2, 4 to 7, and 9 to 11 is the organic EL element 5 illustrated in Figs. 12 and 13. Figs. 1, 2, 4 to 7, and 9 to 11 illustrate that the organic EL elements 5 whose shapes are belt-like seen from a plan view in Fig. 12 are disposed in parallel in the width direction of the organic EL elements 5. That is, in the illustrated examples, the width direction of the organic EL element 5 corresponds to the direction A.

### [Configuration of Organic EL Device]

The organic EL device according to the present invention includes a light emission panel which includes a base material and a plurality of organic EL elements disposed on the base material in parallel in the direction A. The organic EL element includes the organic layer and the electrode terminals (the anode terminal and the cathode terminal). Further, the light emission panel further includes connection portions which are electrically connected with the electrode terminals of each organic EL element.

Electrode terminals (the anode terminal and the cathode terminal) of organic EL elements positioned at both end portions of the light emission panel are electrically connected to an external power supply. Further, by applying a current to the electrode terminals from the external power supply, a light emission layer included in the organic layer emits a beam.

A plurality of organic EL elements in the light emission panel is electrically connected through the connection portion, and therefore the current supplied from the external power supply flows to all organic EL elements in the light emission panel. As a result, a plurality of organic EL elements emits beams.

Further, the organic EL device according to the present invention includes a sealing member which inclusively seals a light emission region formed by a plurality of organic layers, and an inter-layer region sandwiched by two neighboring organic layers in the light emission panel. The sealing member seals the light emission region and the inter-layer region. Consequently, it is possible to prevent the organic layers of all organic EL elements in the light emission panel from contacting an outdoor air.

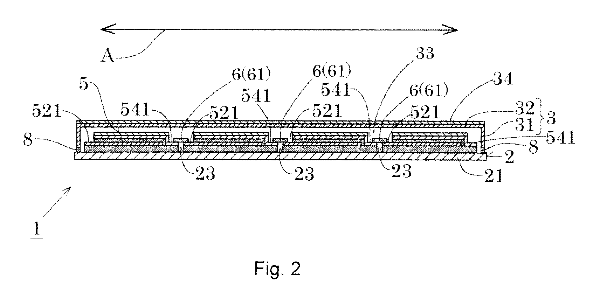

Fig. 1 is a schematic plan view illustrating an organic EL device 1 according to one embodiment of the present invention, and Fig. 2 is a schematic end view of the organic EL device 1.

In addition, in Fig. 1, connector members 61 provided in spaces (a sealing space 33 illustrated in Fig. 2) between a sealing member 3 and a light emission panel 2 are indicated by dashed lines for convenience.

In Figs. 1 and 2. the light emission panel 2 is formed by a base material 21, and a plurality of (e.g. four) organic EL elements 5 which is disposed on the base material 21 in parallel, in a tile pattern and in the direction A. A plurality of organic EL elements 5 whose shapes are nearly belt-like seen from a plan view is disposed in parallel on a regular basis spaced a slight interval apart in the width direction of the organic EL elements 5. The organic EL elements 5 disposed in parallel are fixed to the base material 21.

A sheet member having flexibility is preferably used for the base material. The base material is made of the same material as those of a substrate of a connection substrate and an element substrate of the organic EL element described later, for example.

The base material may be transparent or opaque, and a transparent base material is used to form the bottom-emission organic EL device. Further, the base material having a sealing property (a gas barrier property and a water vapor barrier property) is preferably used to prevent the organic layers of the organic EL elements from contacting an outdoor air.

In this specification, as an exemplary index of transparency, a total light transmittance is 70% or more, is preferably 80% or more. It is to be noted that the total light transmittance is a value measured by a measurement method conforming to JIS K7105 (Method of Testing Optical Characteristics of Plastics).

Furthermore, as an exemplary gas barrier property index, an oxygen transmittance rate is 500 cc/m²•day•atm or less, is preferably 100 cc/m²•day•atm or less and is more preferably 50 cc/m²•day•atm or less. Meanwhile, the oxygen transmittance rate takes a value measured by a measuring method conforming to JIS K7126 at 25°C under the atmosphere of 100%RH.

Further, as an exemplary water vapor barrier property index, a water vapor transmittance rate is 500 g/m²•day or less, is preferably 100 g/m²•day or less and is more preferably 50 g/m²•day or less. Meanwhile, the water vapor transmittance rate takes a value measured by a measuring method conforming to JIS K7129 at 40°C under the atmosphere of 90%RH.

Each organic EL element 5 in the light emission panel 2 is disposed in parallel in the direction A such that the anode terminal 521 and the cathode terminal 541 neighbor to each other. The neighboring anode terminal 521 and cathode terminal 541 are electrically connected through the conductive connector member 61 which is provided across both of the electrode terminals 521 and 541. That is, in Figs. 1 and 2, a connection portion 6 has the connector member 61.

Further, the anode terminal 521 of the organic EL element 5 positioned at one end of the light emission panel 2, and the cathode terminal 541 of the organic EL element 5 positioned at the other end of the light emission panel 2 are connected with lead wires 7 which connect with the external power supply (not illustrated).

In addition, the connection portion 6 has the connector member 61 in Figs. 1 and 2. However, the present invention is not limited to the present embodiment. For example, the neighboring organic EL elements 5 may be disposed such that lateral edges of the neighboring organic EL elements 5 contact each other. In this case, the anode terminal 521 and the cathode terminal 541 of the neighboring organic EL element 5 directly contact, and power is distributed. Consequently, it is possible to remove the connector members 61. In this case, a contact point of the electrode terminals 521 and 541 is the connection portion 6.

Further, in Figs. 1 and 2, the neighboring organic EL elements 5 in the light emission panel 2 are connected in series through the connector members 61. However, each organic EL element 5 may be connected in parallel through a conductive lead wire connected to the electrode terminals 521 and 541 of each organic EL element 5 (not illustrated). In this case, the connection portion 6 includes the lead wire.

In addition, in this specification, the lateral edge of the organic EL element 5 is a portion which makes up an outline of the organic EL element 5 seen from a direction vertical to the surface of the organic EL element 5.

The connector member is not limited in particular as long as the connector member has conductivity, and, for example, a metal mass having conductivity can be used. Further, a material for forming a lead wire is not limited in particular as long as the material has conductivity, and, for example, a material obtained by linearly processing metal having conductivity can be used.

Furthermore, the shapes of the connector member and the lead wire are not limited in particular. In Figs. 1 and 2, the long and thin connector members 61 which have nearly the same lengths as those of the organic EL elements 5 are used.

In the illustrated examples, the light emission panel 2 includes the four organic EL elements 5. However, the number of organic EL elements 5 which form the light emission panel 2 is not limited in particular. One light emission panel 2 is formed using two or more organic EL elements 5, is preferably formed using three to twenty organic EL elements 5 and is more preferably formed using four to fifteen organic EL elements 5.

### [Light Emission Region and Inter-Layer Region]

A plurality of organic EL elements is disposed in the light emission panel, in parallel and in a tile pattern and to form the light emission region formed by a plurality of organic layers, and the inter-layer region sandwiched by two neighboring organic layers. The sealing member seals the light emission region and the inter-layer region.

The light emission region and the inter-layer region will be described in detail below.

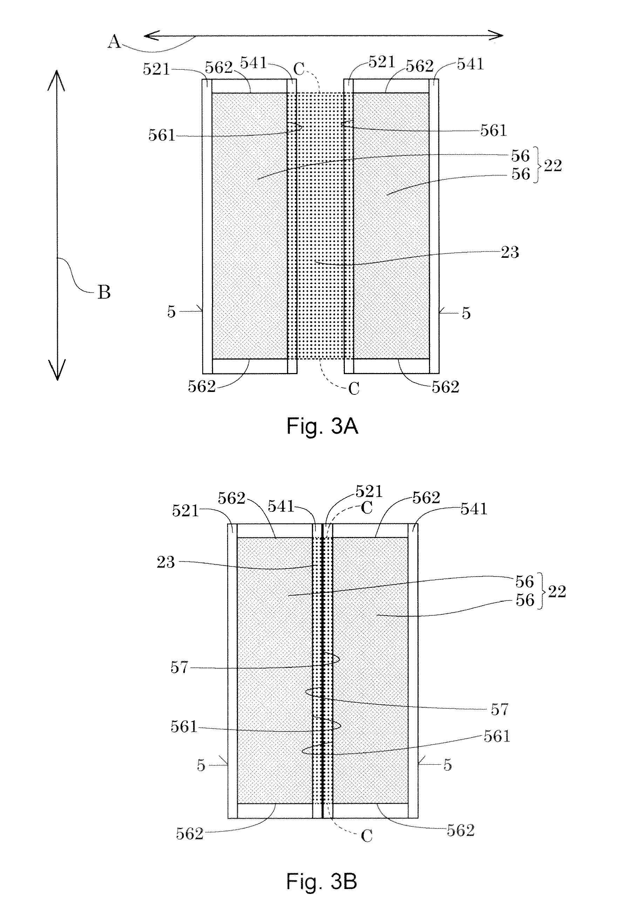

Figs. 3A and 3B are schematic plan views illustrating organic EL devices including two organic EL elements. In addition, in Figs. 3A and 3B, the base material, the connector members, the sealing member and the like included in the organic EL device are not illustrated for ease of description to explain only a relationship between two organic EL elements. Further, the organic EL elements are also illustrated shorter than general organic EL elements. Furthermore, Fig. 3A illustrates a wider interval between the organic EL elements than those of general organic EL elements for ease of description to explain the inter-layer region.

In Figs. 3A and 3B, the two organic EL elements 5 include the surface regions 56 corresponding to the organic layers 53. The organic EL element 5 in Figs. 3A and 3B includes the electrode terminals 521 and 541, and the surface region 56 at a portion except both end portions in longitudinal direction of the organic EL element 5 and the vicinity of the both end portions in longitudinal direction. Grid patterns are applied to the surface regions 56 in Figs. 3A and 3B.

A light emission region 22 is a region formed by adding the surface regions 56 of all organic EL elements 5 included in the organic EL device, and is a region formed by adding the two surface regions 56 and 56 in Figs. 3A and 3B. In addition, in Figs. 1 and 2, the light emission panel 2 includes the four organic EL elements 5, and therefore the four surface regions 56 form the light emission region 22.

As illustrated in Fig. 3A, an inter-layer region 23 is a region surrounded by lateral edges 561 and 561 of the two surface regions 56 and 56 elongated in the direction B, and two virtual lines C and C connecting end portions of lateral edges 562 and 562 of the surface regions 56 and 56 elongated in the direction A. In addition, in Figs. 3A and 3B, the inter-layer region 23 is indicated by an infinite number of dots.

In Fig. 3A, the inter-layer region 23 is a region including the cathode terminal 541 of the organic EL element 5 positioned on the left, the anode terminal 521 of the organic EL element 5 positioned on the right and a region between the electrode terminals 521 and 541.

Further, as illustrated in Fig. 3B, when lateral edges 57 and 57 of the two organic EL elements 5 and 5 elongated in the direction B are disposed in contact with each other, the inter-layer region 23 is a region including the cathode terminal 541 of the organic EL element 5 disposed on the left and the anode terminal 521 of the organic EL element 5 disposed on the right.

In the organic EL device according to the present invention, the sealing member inclusively seals pluralities of surface regions (light emission region) and the inter-layer region. In other words, one sealing member is provided across a plurality of organic EL elements, and pluralities of surface regions (light emission region) and the inter-layer region are collectively sealed by one sealing member.

In addition, in Fig. 3A, the connection portions (connector members) are not illustrated. However, the connection portions (connector members) are preferably sealed by the sealing member. Positions at which the connector members are provided are not limited in particular. However, the connector members are preferably provided such that the connector members are positioned in the inter-layer region 23.

### [Sealing Member]

The sealing member 3 includes a sidewall portion 31 which surrounds at least the light emission region 22 and the inter-layer region 23, and a ceiling portion 32 which covers the light emission region 22 and the inter-layer region 23. In Figs. 1 and 2, the sidewall portion 31 of the sealing member 3 is provided upright from the surface of the base material 21 through adhesive layers 8. The sidewall portion 31 of the sealing member 3 surrounds the periphery of a plurality of organic EL elements 5. Thus, the light emission region 22, the inter-layer regions 23 and the connection portions 6 including the connector members 61 are surrounded by the sidewall portion 31 of the sealing member 3, and covered by the ceiling portion 32 of the sealing member 3. As illustrated in Figs. 1 and 2, the shape of the ceiling portion 32 of the sealing member 3 seen from a plan view is nearly rectangular, and a cross-sectional shape of the sealing member 3 is a nearly reversed U shape.

In addition, in the sealing space 33 between the sealing member 3 and the light emission panel 2, part of the lead wires 7 which electrically connect with the anode terminal 521 and the cathode terminal 541 of the organic EL elements 5 positioned at both ends of the light emission panel 2 are sealed.

The sealing member can prevent an outdoor air from entering the sealing space and, consequently, it is possible to prevent the outdoor air from deteriorating the organic layer.

In addition, members other than the organic EL elements, the connector members and the lead wires may be sealed in the sealing space. In this regard, these members will not be described in this specification and will not be illustrated in the drawings.

Inert gas such as helium gas or nitrogen gas may be filled in the sealing space. Further, a desiccant and/or an oxygen absorber may be disposed in the sealing space.

Preferably, inert gas is filled in the sealing space, and the desiccant and/or the oxygen absorber are disposed.

The desiccant is not limited in particular, and a desiccant which chemically absorbs moisture and keeps a solid state even when the desiccant absorbs moisture is used. Such compounds include sodium oxide, potassium oxide, calcium oxide, barium oxide and the like.

Further, the oxygen absorber is not limited in particular, either, and includes aluminum, iron, natrium, lithium, barium, zinc and the like.

By filling inert gas in the sealing space, it is possible to more effectively prevent the organic layers from contacting an outdoor air. Further, when the outdoor air enters the sealing space, if the desiccant and the oxygen absorber are disposed in the sealing space, it is possible to effectively prevent the entering outdoor air from contacting the organic layer.

Furthermore, a first barrier layer which prevents an outdoor air from entering may be stacked on the sealing member. In Fig. 2, a first barrier layer 34 is stacked on the ceiling portion 32 of the sealing member 3.

A material for forming the first barrier layer is not limited in particular, and includes a metal deposited film, a film made of an oxide of metal or silicon, an oxide nitride film, a nitride film and a metal foil. Metal of the metal deposited film includes, for example, In, Sn, Pb, Cu, Ag and Ti. Examples of the metal oxide include MgO, SiO, SiₓO_{y}, Al₂O₃, GeO, and Ti₂O. Examples of the metal foil include aluminum, copper, and stainless steel. A thickness of the first barrier layer is not limited in particular, but it is 50 nm to 50 µm, for example.

### (Sidewall Portion of Sealing Member)

The sidewall portion of the sealing member is a portion which surrounds at least the light emission region and the inter-layer region.

A material for forming the sidewall portion is not limited in particular as long as the material has the sealing property. The sidewall portion is preferably made of resin having the sealing property.

Such resin includes ethylene vinylalcohol copolymer, polyvinylidene chloride, nylon 6, nylon 66, polymethaxylylene adipamide, amorphous polyamide, polyethylene terephthalate, epoxy resin or a mixture thereof.

Further, a thickness of the sidewall portion is not limited in particular as long as the sidewall portion can secure the sealing property of the sealing member. For example, the thickness of the sidewall portion is 0.3 mm to 3 mm, preferably 0.3 mm to 2 mm, more preferably 0.3 mm to 1 mm.

When the thickness of the sidewall portion is less than 0.3 mm, there is a concern that the sealing property of the sealing member cannot be secured, and, when the thickness of the sidewall portion is more than 3 mm, there is a concern that flexibility of the organic EL device is undermined.

### (Ceiling Portion of Sealing Member)

The ceiling portion of the sealing member is a portion which covers the light emission region and the inter-layer region.

A material for forming the ceiling portion is not limited in particular as long as the material has the sealing property. The ceiling portion is preferably made of a transparent material. By using the transparent material, it is possible to prevent the ceiling portion from blocking beams emitted from the top-emission organic EL elements.

Such a transparent material includes glass, resin or the like. The transparent resin which is the same as that of the material for forming the sidewall portion can be used.

A thickness of the ceiling portion is not limited in particular as long as the ceiling portion can secure the sealing property of the sealing member. For example, the thickness of the ceiling portion is 0.05 mm to 3 mm, preferably 0.1 mm to 2 mm, more preferably 0.1 mm to 1 mm.

A sealing member making method is not limited in particular. The sealing member can be made by, for example, forming the sidewall portion of a bottomless cylindrical shape and then jointing the ceiling portion to block one opening portion of this bottomless cylindrical portion.

In addition, the same resin as that of the material for forming the sidewall portion is preferably used for the ceiling portion of the sealing member. As long as the materials for forming the ceiling portion and the sidewall portion are the same, it is possible to form the sealing member formed by seamlessly integrating the sidewall portion and the ceiling portion by injection molding.

The sealing member without seams between the sidewall portion and the ceiling portion does not cause the ceiling portion and the sidewall portion to peel off. Consequently, it is possible to more effectively prevent an outdoor air from entering.

Modified examples of the present invention will be described below. In this regard, configurations and effects different from those of the above-described embodiment will be described upon explanation of the following modified examples, and the same configurations and the like as those of the above-described embodiment will not be described by employing reference numerals in some cases.

### (First Modified Example of Present Invention)

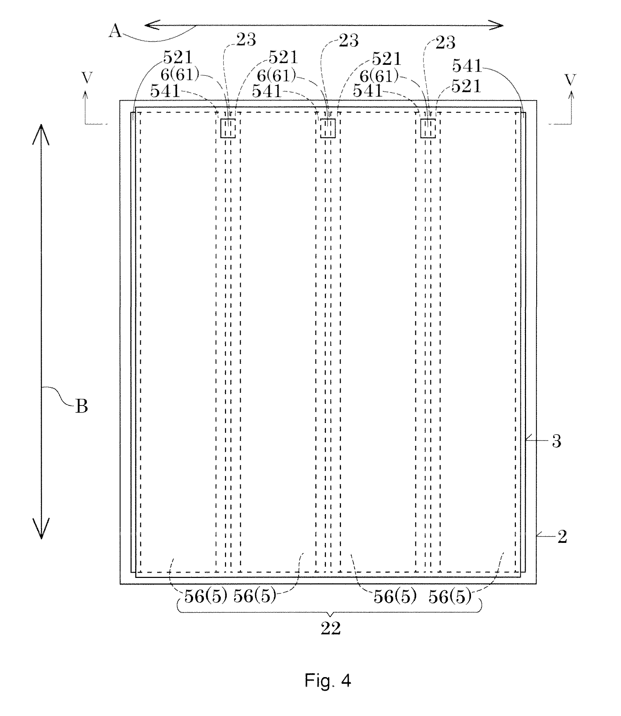

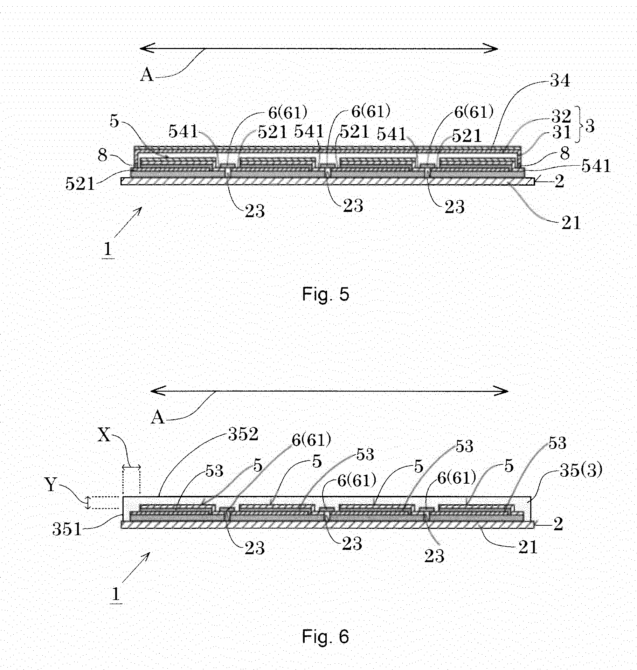

According to the present invention, as illustrated in Figs. 4 and 5, connector members 61 may be provided at one side portion (an upper side portion in Figs. 4 and 5) of a light emission panel 2. By concentrating the connector members 61 at one side portion of the light emission panel 2 in this way, it is possible to reduce a material for forming the connector members 61 and form a lighter organic EL device 1.

Further, according to the present invention, as illustrated in Figs. 4 and 5, electrode terminals 521 and 541 positioned at both ends of the light emission panel 2 may be exposed to an outside of a sealing member 3.

In Figs. 4 and 5, a sidewall portion 31 of the sealing member 3 is provided upright from surfaces of electrode terminals (the anode terminal 521 and the cathode terminal 541) of organic EL elements 5 positioned at the both ends of the light emission panel 2 through an adhesive layer 8.

In the present modified example, a light emission region 22 and inter-layer regions 23 in the light emission panel 2 are sealed in a sealing space 33. Consequently, it is possible to prevent organic layers 53 from contacting an outdoor air.

Further, the sidewall portion 31 is provided upright from the surfaces of the electrode terminals 521 and 541. Therefore, portions from which the electrode terminals 521 and 541 are exposed are formed at an outer side of the sealing member 3. It is possible to connect lead wires illustrated in Fig. 1, to these portions from which the electrode terminals 521 and 541 are exposed (not illustrated in Figs. 4 and 5). Consequently, it is possible to easily exchange the lead wires without detaching the sealing member 3.

### (Second Modified Example of Present Invention)

Further, a sealing member 3 may be a resin layer 35 which covers at least a light emission region 22 and an inter-layer region 23 without a gap. In this case, as illustrated in, for example, Fig. 6, the sealing member 3 formed by the resin layer 35 covers all organic EL elements 5 in a light emission panel 2 without a gap. That is, the light emission region 22 and the inter-layer regions 23, and connection portions 61 including connector members 61 in the light emission panel 2 are sealed by the resin layer 35 which is the sealing member 3.

An above-described first barrier layer 34 may be stacked on the sealing member 3 (resin layer 35) (not illustrated).

In addition, in Fig. 6, hatching is not applied to an end surface of the resin layer 35 for ease of description and an infinite number of dots are applied instead.

The sealing member formed by the resin layer hardly causes the sealing member to peel off at a boundary between a base material and the sealing member, and therefore an outdoor air hardly enters. Consequently, it is possible to effectively prevent organic layers from deteriorating.

Resin used for the resin layer is not limited in particular, and the same resin as that used for an above-described sidewall portion can be used. The resin used for the resin layer is preferably transparent to correspond to the top-emission organic EL element.

In addition, in Fig. 6, the resin layer 35 is provided to cover entire surfaces of electrode terminals positioned at both ends of the light emission panel 2. However, the resin layer 35 may cover only part of the electrode terminals positioned at the both ends of the light emission panel 2 and part of the electrode terminals may be exposed to an outer side of the resin layer 35 (not illustrated).

A material for forming the resin layer 35 is not limited in particular as long as the resin has the sealing property. For example, resins listed as above-described materials for forming the sidewall portion can be used.

As illustrated in Fig. 6, a shortest distance X between a lateral edge surface 351 of the resin layer 35 and an organic layer 53 is preferably 0.5 mm to 4 mm and is more preferably 2 mm to 4 mm. Further, a shortest distance Y between a surface 352 of the resin layer 35 and a surface of the organic layer 53 is preferably 0.05 mm to 3 mm and is more preferably 0.1 mm to 3 mm.

By placing the shortest distances X and Y in the above-described ranges, it is possible to more effectively prevent the organic layers from contacting an outdoor air. When the shortest distances X and Y are shorter than the above-described ranges, there is a concern that an outdoor air is likely to infiltrate an interior of the resin layer, and, when the shortest distances X and Y are longer than the above-described ranges, there is a concern that flexibility of an organic EL device is undermined.

### (Third Modified Example of Present Invention)

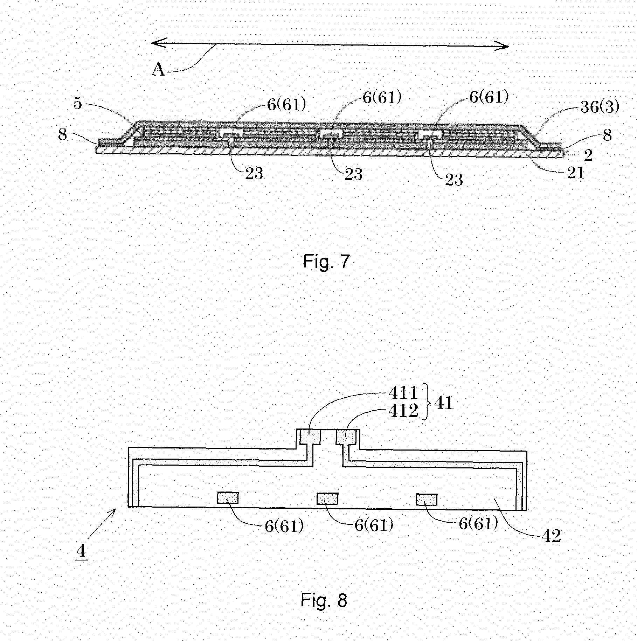

Further, as illustrated in Fig. 7, a sealing member 3 may be a flexible film 36 having flexibility and the sealing property. The flexible film 36 is stacked across surfaces of a plurality of organic EL elements 5 included in a light emission panel 2.

Circumferential portions of the flexible film 36 illustrated in Fig. 7 are adhered onto a base material 21 through adhesive layers 8.

A thickness of the flexible film 36 is not limited in particular as long as the flexible film 36 can secure the sealing property, and is, for example. 0.05 mm to 3 mm, is preferably 0.1 mm to 2 mm and is more preferably 0.1 mm to 1 mm.

Further, a material for forming the flexible film 36 is not limited in particular as long as the resin has the sealing property. For example, resins listed as above-described materials for forming the sidewall portion can be used. Furthermore, the flexible film 36 may adopt a single layer structure, or a multilayer structure including two or more layers.

### (Fourth Modified Example of Present Invention)

An organic EL device according to the present invention may include a connection substrate which includes connector members and a substrate on a surface of which the connector members are disposed. When the connection substrate is connected to anode terminals and cathode terminals of a plurality of organic EL elements in a light emission panel, the respective organic EL elements are electrically connected. Further, a sealing member inclusively seals the connector members included in the connection substrate.

### (Connection Substrate)

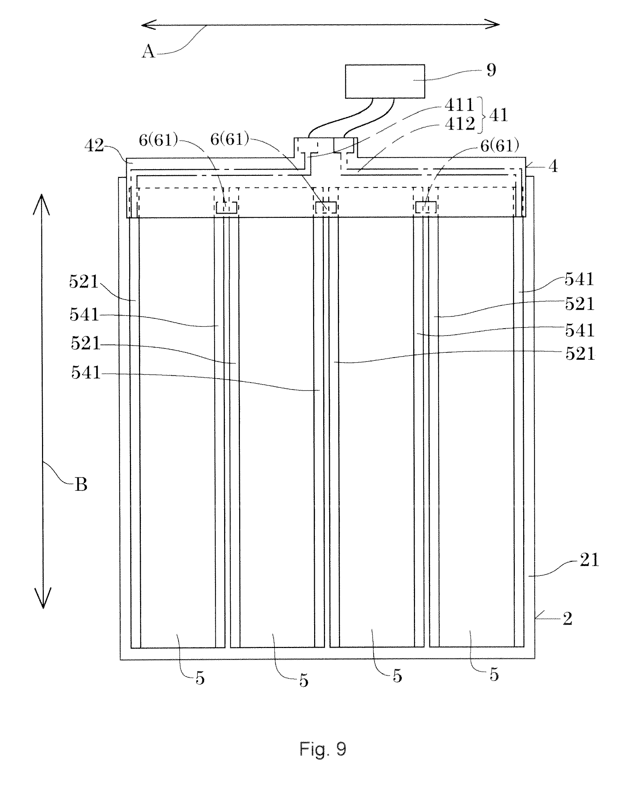

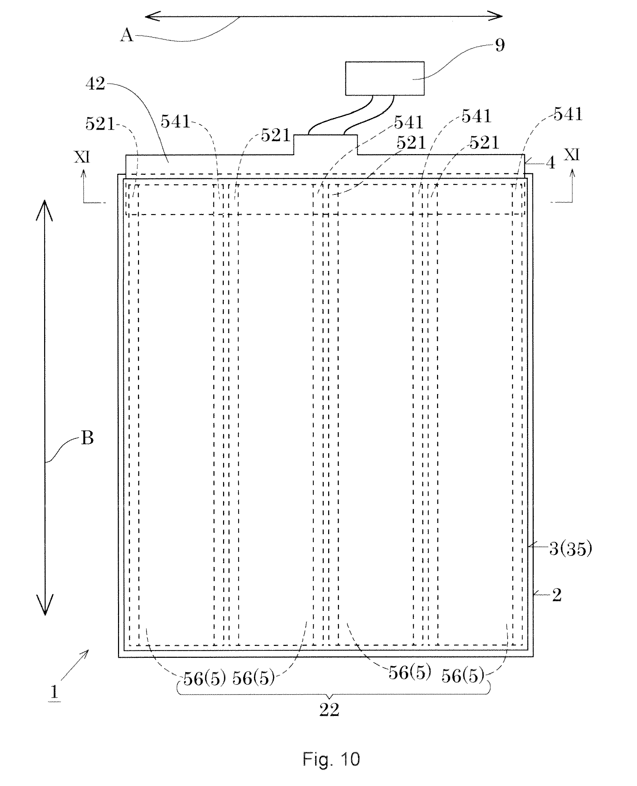

Fig. 8 is a schematic back view illustrating one embodiment of a connection substrate 4 used in the present invention, and Fig. 9 is a schematic plan view illustrating a state where the connection substrate 4 and a plurality of organic EL elements 5 (light emission panel 2) are electrically connected. Fig. 10 is a schematic plan view illustrating an organic EL device 1 according to the present invention which is formed by providing a sealing member 3 to the connection substrate 4 and a plurality of organic EL elements 5 in Fig. 9.

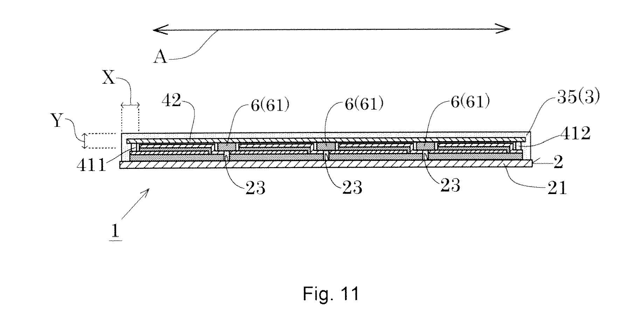

In addition, for ease of description, in Fig. 8, an infinite number of dots are applied to first and second connection circuits 411 and 412 of the connection substrate 4, and grid patterns are applied to connector members 61 which include connection portions 6. Further, for ease of description, in Fig. 9, the first and second connection circuits 411 and 412 of the connection substrate 4, and the connector members 61 are indicated by dashed lines. For ease of description, in Fig. 11, hatching is not applied to an end surface of a resin layer 35 and an infinite number of dots are applied instead.

As illustrated in Fig. 8, the connection substrate 4 includes a connection circuit 41, the connector members 61, a substrate 42 on which the connection circuit 41 and the connector members 61 are provided. The connection circuit 41 is a member which connects the organic EL elements 5 in the light emission panel 2 to an external power supply 9. The connector member 61 is a member which electrically connects electrode terminals (an anode terminal 521 and a cathode terminal 541) of the two neighboring organic EL elements 5 in the light emission panel 2.

The connection circuit 41 includes the first connection circuit 411 which connects to the anode terminal 521 of the organic EL element 5, and the second connection circuit 412 which connects to the cathode terminal 541 of the organic EL element 5. One end portion of both of the connection circuits 411 and 412 is connected to the anode terminal 521 or the cathode terminal 541 of the organic EL element 5, and the other end portion of both of the connection circuits 411 and 412 is connected to the external power supply 9.

The connector member 61 is a member which is formed across the anode terminal 521 and the cathode terminal 541 of the two neighboring organic EL elements 5 as described above. Further, the neighboring organic EL elements 5 in the light emission panel 2 are electrically connected through the connector members 61.

Hence, a current supplied from the external power supply 9 connected to the other end portion of the first and second connection circuits 411 and 412 flows to the organic EL elements 5 positioned at both end portions of the light emission panel 2 through the connection circuit 41, and flows to all organic EL elements 5 in the light emission panel 2 through the connector members 61. As a result, the light emission panel 2 emits beams.

The shape of the substrate 42 seen from a plan view is not limited in particular, and has, for example, a nearly rectangular shape whose one side partially projects as illustrated in Fig. 8. At this projecting portion in the planar surface of the substrate 42, the other end portion of the first connection circuit 411 and the other end portion of the second connection circuit 412 are disposed. Further, at an end portion of the substrate 42 opposing to the projecting portion in the planar surface of the substrate 42, the one end portion of the first connection circuit 411 and the one end portion of the second connection circuit 412 are disposed. Furthermore, the three connector members 61 are discontinuously provided spaced a predetermined interval apart between the one end portion of the first connection circuit 411 and the one end portion of the second connection circuit 412. The first connection circuit 411, the second connection circuit 412 and each connector member 61 are independent from each other, and are not electrically connected.

In addition, the connection substrate may include portions other than the first and second connection circuits and the connector members. In this regard, these members will not be described in this specification and will not be illustrated in the drawings.

A method of forming the connection circuits and the connector members on the substrate is not limited in particular. The method includes a method of soldering the connection circuits and the connector members onto the substrate and a method of adhering a thin film of a conductive material onto the substrate (a so-called method of forming the connection circuits and the connector members by print wiring). In addition, the connection circuits and the connector members are preferably formed by the same method, yet can also be formed by different methods. For example, the connection circuits may be formed by a printed wiring, and the connector members may be formed by soldering.

As illustrated in Figs. 9 to 11, each organic EL element 5 in the light emission panel 2 is disposed in parallel in a direction A such that the anode terminal 521 and the cathode terminal 541 neighbor to each other except electrode terminals (the anode terminal 521 and the cathode terminal 541) positioned at both ends of the light emission panel 2. Thus, the neighboring anode terminal 521 and cathode terminal 541 are electrically connected through the connector member 61 of the connection substrate 4. Further, the anode terminal 521 and the cathode terminal 541 positioned at the both ends of the light emission panel 2 are connected to the first connection circuit 411 and the second connection circuit 412 of the connection substrate 4.

A portion at which the electrode terminals 521 and 541 of the two neighboring organic EL elements 5 are connected in the light emission panel 2 is sealed by the sealing member.

More specifically, as illustrated in Figs. 9 to 11, the connection substrate 4 is connected so as to cover one side portion of the light emission panel 2. That is, when the connection substrate 4 is connected to the anode terminal 521 and the cathode terminal 541 of a plurality of organic EL elements 5 in the light emission panel 2, the respective organic EL elements 5 are electrically connected and a plurality of organic EL elements 5 is integrated.

Further, the resin layer 35 which is the sealing member 3 covers without a gap a plurality of organic EL elements 5 in the light emission panel 2, and the connection substrate 4 connected to a plurality of organic EL elements 5. That is, a light emission region 22, inter-layer regions 23, and connection portions 6 including connector members 61 in the light emission panel 2 are embedded by the resin layer 35 which is the sealing member 3.

Consequently, the sealing member 3 (resin layer 35) can not only prevent organic layers 53 from contacting an outdoor air, but also strongly fix connection between a plurality of organic EL elements 5 and the connection substrate 4. The connection between a plurality of organic EL elements 5 and the connection substrate 4 is strongly fixed and, consequently, it is possible to prevent the connection substrate 4 from dropping.

In addition, in Fig. 11, a shortest distance X between a lateral edge surface 351 of the resin layer 35 and the organic layer 53 is preferably 0.5 mm to 4 mm and is more preferably 2 mm to 4 mm. Further, a shortest distance Z between a surface 352 of the resin layer 35 and a surface of the organic layer 53 is preferably 0.05 mm to 5 mm and is more preferably 0.1 mm to 5 mm.

### (Substrate of Connection Substrate)

The connection substrate electrically connects a plurality of organic EL elements in the light emission panel, supplies currents from the external power supply to the light emission panel and integrates a plurality of organic EL elements in the light emission panel. One connection substrate is attached to one light emission panel.

In particular, the substrate of the connection substrate is the member which integrates a plurality of organic EL elements in the light emission panel.

The substrate which is a component member of the connection substrate is not limited in particular. However, a flexible film-shaped member is preferably used. An organic EL device having flexibility can be formed by using a flexible substrate.

As the flexible substrate, a resin film is preferably used. Examples of the material for forming the resin film include polyester-based resins such as polyethylene terephthalate (PET), polyethylene naphthalate (PEN), and polybutylene terephthalate (PBT); olefin-based resins having an α-olefin as a monomer component, such as polyethylene (PE), polypropylene (PP), polymethylpentene (PMP), ethylene-propylene copolymers, and ethylene-vinyl acetate copolymers (EVA); polyvinyl chloride (PVC); vinyl acetate-based resins; polycarbonate (PC); polyphenylene sulfide (PPS); amide-based resins such as polyamide (nylon) and wholly aromatic polyamide (aramid); polyimide-based resins; and polyether ether ketone (PEEK), and preferably polyimide-based resins.

A thickness of the substrate is not particularly limited, but it is preferably 10 µm to 50 µm, more preferably 10 µm to 30 µm.

Further, the present invention uses a substrate having an insulation property so as not to electrically connect the connection circuit and the connector members. The materials for forming a resin film listed above generally have the insulation property. In addition, when the substrate itself does not have the insulation property (the substrate has conductivity), a region of the surface of the substrate at which at least the connection circuit and the connector members are provided is provided with an insulation layer.

The substrate may be transparent or may be opaque. The transparent substrate is preferably used. By using the transparent substrate, it is possible to prevent the connection substrate from blocking beams emitted from the top-emission organic EL elements.

The size of the substrate is not limited in particular, and can be optionally designed.

Further, the shape of the substrate seen from a plan view is not limited in particular, and can be optionally changed according to alignment of the organic EL elements in the light emission panel.

### (Connection Circuit of Connection Substrate)

The connection circuit is a portion which supplies a current from the external power supply to the light emission panel. The connection circuit includes the first connection circuit which electrically connects to the anode terminal of the organic EL element, and the second connection circuit which electrically connects to the cathode terminal.

Respective one end portions of the first and second connection circuits are connected to the anode terminal and the cathode terminal, and the respective other end portions are connected to an anode and a cathode of the external power supply. In this regard, the respective other end portions of the first and second connection circuits may be directly connected to the external power supply, and may be indirectly connected to the external power supply through another member such as an IC chip.

The connection circuit is made of a material having conductivity, and a shape of the connection circuit is not limited in particular. For example, the connection circuit is preferably formed by a wiring linearly formed on the substrate, and is more preferably formed by a printed wiring by adhering a thin film of a conductive material onto the substrate.

A material for forming the connection circuit is not limited in particular, and includes conductive materials such as metal of platinum, gold, silver, copper, nickel, cobalt, titanium and the like; a metal oxide of ITO and the like; and an inorganic material of graphite and the like. A material for forming the connection portions is preferably copper since an electrical resistance is low.

### (Connector Member of Connection Substrate)

The connector member is a portion which is provided across an anode terminal and a cathode terminal of the neighboring organic EL elements in the light emission panel while electrically connecting the anode terminal and the cathode terminal.

The shape of the connector member seen from a plan view is not limited in particular, and is preferably a thin and long shape seen from a plan view. The thin and long shape seen from a plan view makes it possible to connect the neighboring anode terminal and cathode terminal even when positions of the connection substrate and a plurality of organic EL elements (light emission panel) are displaced more or less upon connection.

The connector members are made of a material having conductivity. The connector member may be formed by a wiring such as the above-described printed wiring, and may be formed by a mass of a conductive material fixed onto the substrate. An exemplary material for forming the connector members is the material for forming the connection circuit.

The connection substrate formed by providing the connection circuit and the connector members on the substrate having flexibility by way of the printed wiring is particularly preferably used. The connection substrate provided on the flexible substrate by way of the printed wiring is generally referred to as a flexible printed circuit (FPC).

It is possible to easily change a wiring pattern by using the FPC, and easily set an arrangement of the connector members and the connection circuit. Consequently, it is possible to easily form the connection substrate which is suitable for the arrangement of the organic EL elements in the light emission panel at low cost.

### (Organic EL Element)

The organic EL element used in the organic EL device according to the present invention is not limited in particular as long as the organic EL element includes an organic layer, an anode terminal and a cathode terminal.

In this regard, the organic EL element illustrated in Figs. 12 and 13 is preferably used as described above. A layer configuration of the organic EL element will be described below.

### (Element Substrate of Organic EL Element)

An element substrate is not limited in particular, but examples include a glass substrate, a metal substrate, a synthetic resin substrate, and a ceramic substrate. Examples of the synthetic resin substrate include flexible synthetic resin films such as those of polyester-based resins such as polyethylene terephthalate (PET), polyethylene naphthalate (PEN), and polybutylene terephthalate (PBT); olefin-based resins having an α-olefin as a monomer component, such as polyethylene (PE), polypropylene (PP), polymethylpentene (PMP), ethylene-propylene copolymers, and ethylene-vinyl acetate copolymers (EVA); polyvinyl chloride (PVC); vinyl acetate-based resins; polycarbonate (PC); polyphenylene sulfide (PPS); amide-based resins such as polyamide (nylon) and wholly aromatic polyamide (aramid); polyimide-based resins; and polyether ether ketone (PEEK). Examples of the metal substrate include flexible thin plates formed of stainless steel, copper, titanium, aluminum, and alloys.

For preventing a rise in temperature of the organic EL device at the time of driving, the element substrate is preferably excellent in heat dissipation. The element substrate preferably has sealing properties.

When a metal substrate is used, an insulating layer is provided on a surface of the metal substrate in order to insulate the substrate against an electrode formed on the surface thereof.

### (Anode Layer of Organic EL Element)

An anode layer is a film having conductivity.

The formation material of the anode layer is not limited in particular, but examples include indium tin oxide (ITO); indium tin oxide including silicon oxide (ITSO); aluminum; gold; platinum; nickel; tungsten; copper; and an alloy. A thickness of the anode layer is not limited in particular, but it is usually 0.01 µm to 1.0 µm.

As the formation method of the anode layer, an optimum method can be employed depending on the formation material, and examples of the method include a sputtering method, a vapor deposition method, and an ink-jet method. For example, when the anode layer is formed using a metal, the vapor deposition method can be used.

An anode layer 52 of the organic EL element 5 illustrated in Figs. 12 and 13 includes the anode terminal 521 from which one end portion of the anode layer 52 is exposed (a left end portion in Figs. 12 and 13). In this regard, the anode terminal 521 only needs to be capable of distributing a current from the external power supply, to the anode layer 52, and may not be a portion from which the anode layer 52 is exposed. By, for example, stacking an auxiliary electrode layer on the surface of the exposed anode layer 52, the anode terminal 521 may be formed (not illustrated). By applying a voltage through the auxiliary electrode layer, it is possible to apply uniformly the voltage to the entire organic EL layer.

### (Organic Layer of Organic EL Element)

An organic layer is a laminate structure composed of at least two function layers. Examples of a structure of the organic layer include (A) a structure composed of three layers including a positive hole transport layer, a light emission layer, and an electron transport layer: (B) a structure composed of two layers including a positive hole transport layer and a light emission layer; and (C) a structure composed of two layers including a light emission layer and an electron transport layer.

In the organic layer of the above-mentioned (B), the light emission layer also works as an electron transport layer. In the organic layer of the above-mentioned (C), the light emission layer works as a positive hole transport layer.

The organic layer of the organic EL element used in the present invention may adopt one of the structures (A) to (C). The organic EL element in Fig. 11 adopts the structure (A). The organic layer adopting the structure (A) will be described below.

In Fig. 13, a hole transport layer 531 included in the organic layer 53 has a function of injecting holes in a light emission layer 532, and an electron transport layer 533 has a function of injecting electrons in the light emission layer 532.

The electron and the hole injected from the anode layer 52 and a cathode layer 54 to the light emission layer 532 recouple in the organic EL elements 5 to produce an exciton. When this exciton returns to a basic state, the light emission layer emits a beam.

The positive hole transport layer is provided on the surface of the anode layer. An arbitrary function layer other than the anode layer and the positive hole transport layer may be interposed between the anode layer and the positive hole transport layer under the conditions in which the light emitting efficiency of the organic EL element is not lowered.

For example, the positive hole injection layer may be provided on the surface of the anode layer, and the positive hole transport layer may be provided on the surface of the positive hole injection layer. The positive hole injection layer is a layer having a function of aiding injection of a positive hole from the anode layer to the positive hole transport layer.

By providing a positive hole injection layer, holes are more easily injected to the light emission layer from the hole transport layer.

In addition, using as a material for forming the hole transport layer a material which has a hole transport function and a positive hole injection function in combination makes it possible to form a hole transport layer which substantially has a function of the positive hole injection layer, too, even if the positive hole injection layer is not provided.

A formation material of the positive hole transport layer is not limited in particular as long as the formation material has a positive hole transport function. Examples of the formation material of the positive hole transport layer include an aromatic amine compound such as 4,4',4"-tris(carbazole-9-yl)-triphenyl amine (abbreviation: TcTa); a carbazole derivative such as 1,3-bis(N-carbazolyl) benzene; a spiro compound such as N,N'-bis(naphthalene-1-yl)-N,N'-bis(phenyl)-9,9'-spiro-bisfluorene (abbreviation: Spiro-NPB); a polymer compound; and the like. The formation material of the positive hole transport layer may be used singly or in combination of two or more formation materials. Furthermore, the positive hole transport layer may be a multi-layer structure having two or more layers.

A material for forming the positive hole injection layer is not limited in particular, and includes, for example, a metal oxide such as a vanadium oxide, a niobium oxide and tantalum oxide; a phthalocyanine compound such as phthalocyanine; a polycyclic heteroaromatic compound such as hexa-aza-triphenylene-hexa-cabonitrile (abbreviation: HAT-CN); a polymer of a mixture of 3,4-ethylenedioxythiophene and polystyrene sulfonate (abbreviation: PEDOT/PSS): and the like. The formation material of the positive hole injection layer may be used singly or in combination of two or more formation materials. Furthermore, the positive hole transport layer may be a multi-layer structure having two or more layers.

A thickness of the positive hole transport layer and the positive hole injection layer is not limited in particular, but the thickness of 1 nm to 500 nm is preferable from the viewpoint of reducing drive voltage.

As the formation method of the positive hole transport layer and the positive hole injection layer, an optimum method can be employed depending on the formation material, and examples of the method include a sputtering method, a vapor deposition method, an ink-jet method, and a coating method.

A light emission layer is provided on the surface of the positive hole transport layer.

A formation material of the light emission layer is not limited in particular as long as it has light emitting property. Examples of the formation material of the light emission layer include a low molecular light emission material such as a low molecular fluorescence emission material, and a low molecular phosphorescence emission material.

Examples of the low molecular light emission material include an aromatic dimethylidene compound such as 4,4'-bis(2,2'-diphenyl vinyl)-biphenyl (abbreviation: DPVBi); an oxadiazole compound such as 5-methyl-2-[2-[4-(5-methyl-2-benzoxazolyl)phenyl]vinyl]benzoxazole; a triazole derivative such as 3-(4-biphenyl-yl)-4-phenyl-5-t-butyl phenyl-1,2,4-triazole; a styryl benzene compound such as 1,4-bis(2-methyl styryl)benzene; a benzoquinone derivative; a naphthoquinone derivative; an anthraquinone derivative; a fluorenone derivative; an organic metal complex such as an azomethine-zinc complex, tris(8-quinolinolato) aluminum (Alq₃), and the like.

Furthermore, as the formation material for the light emission layer, a host material doped with light emitting dopant material may be used.

For the host material, for example, the above-mentioned low molecular light emission material can be used, and, other than this, a carbazole derivative such as 1,3,5-tris(carbazo-9-yl)benzene (abbreviation: TCP), 1,3-bis(N-carbazolyl)benzene (abbreviation: mCP), 2,6-bis(N-carbazolyl)pyridine, 9,9-di(4-dicarbazole-benzyl)fluorene (abbreviation: CPF), 4,4'-bis(carbazole-9-yl)-9,9-dimethyl-fluorene (abbreviation: DMFL-CBP), and the like can be used.

Examples of the dopant material include a styryl derivative: a perylene derivative; a phosphorescence emission metal complex including an organic iridium complex such as tris(2-phenyl pyridyl)iridium (III) (Ir(ppy)₃), tris(1-phenyl isoquinoline)iridium (III) (Ir(piq)₃), and bis(1-phenyl isoquinoline) (acetylacetonato) iridium (III) (abbreviation: Ir(piq)₂(acac)), and the like.

Furthermore, the formation material of the light emission layer may include such as the formation material of the positive hole transport layer mentioned above, the formation material of the electron transport layer mentioned below, and various additives.

A thickness of the light emission layer is not limited in particular, but the thickness of 2 nm to 500 nm is preferable, for example.

As the formation method of the light emission layer, an optimum method can be employed depending on the formation material, but usually the vapor deposition method is used.

The electron transport layer is provided on the surface of the light emission layer (the back surface of the cathode layer). An arbitrary function layer other than the cathode layer and the electron transport layer may be interposed between the cathode layer and the electron transport layer under the conditions in which the light emitting efficiency of the organic EL element is not lowered.

For example, the electron injection layer may be provided on the surface of the electron transport layer, and the cathode layer may be provided on the surface of the electron injection layer. The electron injection layer is a layer having a function of aiding injection of an electron from the cathode layer to the electron transport layer.

By providing an electron injection layer, electrons are more easily injected to the light emission layer from the electron transport layer.

In addition, using as a material for forming the electron transport layer a material which has an electron transport function and an electron injection function in combination makes it possible to form an electron transport layer which substantially has a function of the electron injection layer, too, even if the electron injection layer is not provided.

A formation material of the electron transport layer is not limited in particular as long as it is a material having an electron transport function. Examples of the formation material of the electron transport layer include a metal complex such as tris(8-quinolinolato) aluminum (abbreviation: Alq₃), bis(2-methyl-8-quinolinolato)(4-phenyl phenolate) aluminum (abbreviation: BAlq); a heteroaromatic compound such as 2,7-bis[2-(2,2'-bipyridine-6-yl)-1,3,4-oxadiazo-5-yl]-9,9-dimethyl fluorene (abbreviation: Bpy-FOXD), 2-(4-biphenylyl)-5-(4-tert-butyl phenyl)-1,3,4-oxadiazole (abbreviation: PBD), 1,3-bis[5-(p-tert-butyl pheny-1)-1,3,4-oxadiazole-2-y-l]benzene (abbreviation: OXD-7), and 2,2',2"-(1,3,5-phenylene)-tris(1-phenyl-1H-benzimidazole) (abbreviation: TPBi); and a polymer compound such as poly(2,5-pyridine-diyl) (abbreviation: PPy). The formation material of the electron transport layer may be used singly or in combination of two or more types. Furthermore, the electron transport layer may have a multi-layered structure composed of two or more layers.

The material for forming the electron injection layer is not limited in particular, and includes, for example, an alkali metal compound such as lithium fluoride (LiF) and cesium fluoride (CsF); alkaline earth metal compound such as calcium fluoride (CaF₂); the above-described materials for forming the electron transport layer; and the like. The formation material of the electron injection layer may be used singly or in combination of two or more formation materials. Furthermore, the electron injection layer may be a multi-layer structure composed of two or more layers.

A thickness of the electron transport layer and the electron injection layer is not limited in particular, but the thickness of 1 nm to 500 nm is preferable from the viewpoint of reducing drive voltage.

As the formation method of the electron transport layer and the electron injection layer, an optimum method can be employed depending on the formation material, and examples of the method include a sputtering method, a vapor deposition method, an ink-jet method, and a coating method.

### (Cathode Layer of Organic EL Element)

The cathode layer is a film having conductivity.

Under a condition that light emission efficiency of the organic EL element is not lowered, an arbitrary functional layer other than the cathode layer and the electron transport layer may be interposed between the cathode layer and the electron transport layer.

A formation material of the cathode layer is not limited in particular. A transparent cathode layer is used when a top emission organic EL element is formed. Examples of the formation material of the cathode layer which is transparent and has electric conductivity include indium tin oxide (ITO); indium tin oxide including silicon oxide (ITSO); zinc oxide in which electric conductive metal such as aluminum is added (ZnO : Al); and a magnesium-silver alloy, and the like. A thickness of the cathode layer is not limited in particular, but it is usually 0.01 µm to 1.0 µm.

As the formation method of the cathode layer, an optimum method can be employed depending on the formation material, and examples of the method include a sputtering method, a vapor deposition method, and an inkjet method. For example, the sputtering method is used when the cathode layer is formed of ITO and the vapor deposition method is used when the cathode layer is formed of the laminated film of a magnesium-silver alloy or a magnesium-silver.

In Fig. 13, the cathode layer 54 includes the cathode terminal 541 from which one end portion (the right end portion in Fig. 13) of the cathode layer 54 is exposed. In this regard, the cathode terminal 541 only needs to be capable of distributing a current from an outside, to the cathode layer 54, and may not be a portion from which the cathode layer 54 is exposed. By, for example, stacking an auxiliary electrode layer on a surface of the exposed cathode layer 54 similar to the above-described anode layer 52, the cathode terminal 541 can also be formed (not illustrated).

### (Second Barrier Layer of Organic EL Element)

The second barrier layer is a layer which prevents an outdoor air from contacting the organic layer 53. In Fig. 13. a second barrier layer 55 is stacked on the cathode layer 54.

A material for forming the second barrier layer is not limited in particular, and the same material as the material for forming the first barrier layer can be used. A thickness of the second barrier layer is not limited in particular, and is, for example, 50 nm to 50 µm.

### [Organic EL Device Manufacturing Method]

An organic EL device manufacturing method according to the present invention includes: a light emission panel forming step including a disposing step of disposing a plurality of organic EL elements each including an organic layer and electrode terminals, on a base material in parallel in a tile pattern, and a connecting step of electrically connecting the electrode terminals of each organic EL element to form a connection portion.

Further, the organic EL element manufacturing method according to the present invention includes a sealing step of inclusively sealing using a sealing member a light emission region formed by a plurality of organic layers, and an inter-layer region sandwiched by two neighboring organic layers, in the light emission panel.

### (Light Emission Panel Forming Step)

The light emission panel forming step includes the disposing step and the connecting step.

The disposing step is a step of disposing a plurality of organic EL elements on the base material in parallel in the tile pattern.

In this regard, "disposing a plurality of organic EL elements in a tile pattern" indicates that the respective organic EL elements are aligned without overlapping each other. In the disposing step, the respective organic EL elements may be aligned to contact each other or may be aligned spaced predetermined intervals apart from each other.

When the respective organic EL elements are aligned spaced predetermined intervals apart from each other, all of these intervals may be fixed or may be different. In this regard, each organic EL element is preferably aligned spaced fixed intervals apart from each other.

The intervals between the respective organic EL elements are not limited in particular, and are usually 0.1 mm to 0.5 mm and are preferably 0.1 mm to 0.3 mm.

The connecting step is a step of forming a connection portion by electrically connecting electrode terminals of respective organic EL elements.

When, for example, the organic EL elements are aligned to contact each other in the disposing step, the anode terminal of one of the neighboring organic EL elements and the cathode terminal of the other organic EL element contact to form the connection portion.

Further, when, for example, the organic EL elements are aligned space predetermined intervals apart in the disposing step, the anode terminal and the cathode terminal of the two neighboring organic EL elements are electrically connected using the connector member to form the connection portion. In this case, the connection portion includes a connector member.

In the connecting step, the independent connector members may be used or the connection substrates having the connector members used in Modified Example 3 of the present invention may be used.

Further, the connecting step includes a step of connecting to the external power supply the anode terminal and the cathode terminal of the organic EL elements positioned at both ends of the light emission panel.

When the independent connector members are used, the independent lead wires are connected to the electrode terminals of the organic EL elements. On the other hand, when the connection substrate having the connector members and the connection circuits used in Modified Example 3 of the present invention is used, it is not necessary to connect the independent lead wires to the electrode terminals of the organic EL elements.

When the independent connector members and the lead wires are used, a method of connecting these members and the electrode terminals is not limited in particular. The connecting method such as wire bonding or solder reflow can be adopted.

Further, even when the connection substrate is used, a method of connecting the connection substrate and the electrode terminals is not limited in particular. A connection method such as soldering or connection using an anisotropic conductive film (ACF) can be adopted. Preferably, the connection substrate is connected to a plurality of organic EL elements (light emission panel) using the ACF.

### (Sealing Step)

A sealing step is a step of inclusively sealing using the sealing member a light emission region formed by a plurality of organic layers, and an inter-layer region sandwiched by two neighboring organic layers in the light emission panel.

A case where the sealing member is the sealing member including the sidewall portion and the ceiling portion, a case where a sealing member is a resin layer and a case where the sealing member is a flexible film will be described.

When the sealing member is the sealing member including the sidewall portion and the ceiling portion, the organic layers are sealed by covering the light emission panel with the sealing member prepared in advance. More specifically, the sealing member is adhered by applying an adhesive to the end portions of the sidewall portion of the sealing member, laminating the sealing member to the base material or the electrode terminals of the organic EL elements and then solidifying the adhesive.

In addition, when the sealing member is adhered onto the base material and the independent lead wires are connected to the electrode terminals positioned at the both ends of the light emission panel, the sealing member partially including the lead wires is adhered onto the base material. That is, part of the lead wires are sealed in the sealing space by the sealing step, and the other part is exposed to an outside of the sealing space.

In addition, when such a sealing member is used, the sealing step is preferably performed under the atmosphere of inert gas. By performing the sealing step under such an atmosphere, it is possible to fill the inert gas in the sealing space in parallel to the sealing step.

Next, when the sealing member is the resin layer, the light emission region and the inter-layer region are sealed by applying melted resin onto the base material and then solidifying the applied melted resin. By applying the melted resin onto the base material, a plurality of organic EL elements in the light emission panel is covered without a gap by the resin layer (i.e., embedded by the resin layer).

In addition, when the independent lead wires are connected to the electrode terminals positioned at the both ends of the light emission panel, the sealing member (resin layer) partially embeds these lead wires. That is, part of the lead wires are embedded by the resin layer by the sealing step, and the other part is exposed to an outside of the resin layer.

Further, when the sealing member is the flexible film, the light emission region and the inter-layer region are sealed by applying an adhesive to an entire surface of the flexible film, and then laminating the flexible film on the base material to cover a plurality of organic EL elements in the light emission panel.

In the sealing step, the light emission region and the inter-layer region and, in addition, the connection portions formed in the connecting step are preferably sealed inclusively. That is, when the connector member is used in the connecting step, the connection portion including the connector member is sealed in the sealing step.

When the connection substrate is used in the connecting step, it is possible to make connection between the connection substrate and the light emission panel stronger by sealing the connection portion including the connector member.

The organic EL device manufacturing method according to the present invention may further include a step of stacking the first barrier layer on the sealing member after the sealing step. By providing the first barrier layer, the organic layers hardly contact an outdoor air.

The organic EL device and the organic EL device manufacturing method according to the present invention are not limited to those in the above-described embodiment, and design changes can be optionally made within a scope intended by the present invention.

### EXAMPLES

The present invention will be described below with reference to examples and comparative examples. In addition, the present invention is not limited to the following examples alone.

### [Example 1]

### (Making of Element Substrate Including Insulation Layer)

A stainless steel plate (SUS304) having the thickness of 50µm was coated with acrylic resin (manufactured by JSR corporation, trade name "JEM-477") using a wire bar, and was heated at 220°C for 60 minutes in a clean oven to cure the acrylic resin and form an insulation layer having the thickness of 2 µm. Thus, an element substrate including the stainless steel plate and the insulation layer was made.

### (Making of Organic EL Element)

According to a vacuum deposition method, an anode layer formed by an aluminum film having the thickness of 100 nm, a positive hole injection layer made of a HAT-CN (1,4,5,8,9,12-hexa-aza-triphenylene-hexa-cabonitrile) film having the thickness of 10 nm, a hole transport layer made of an NPB (N,N'-bis(naphthalene-1-yl)-N,N'-bis(pheny-1)-benzidine) film having the thickness of 50 nm, a light emission layer (which also works as an electron transport layer) made by an Alq(tris(8-quinolinolato)aluminum) film having the thickness of 45 nm, an electron injection layer made by a lithium fluoride film having the thickness of 0.5 nm, a cathode layer made by a Mg/Ag codeposited film having the thickness of 5 nm/15 nm, and a refractive index adjustment layer made of molybdenum troxide having the thickness of 60 nm were deposited on the insulation layer of the element substrate in this order. Thus, an organic EL layer was formed on the insulation layer of the element substrate to make an organic EL element.

### (Formation of Second Barrier Layer)

A SiN film having the thickness of 200 nm was stacked by a spattering method to cover a region (surface region) corresponding to the organic layer on the refractive index adjustment layer.

Further, an adhesive layer having the thickness of 20 µm was formed by stacking on the region an adhesive whose main component was low water content epoxy. Furthermore, a PET film (manufactured by Mitsubishi Plastics, Inc., trade name "DIAFOIL") on which the SiN of 200 nm was stacked was vacuum-laminated on the SiN film under the condition that the PET film was heated at 80°C. Subsequently, the adhesive layer was heated at 100°C for two hours, and was cured. Thus, the SiN stacked PET film was laminated on the SiN film across the adhesive layer. In addiction, a water vapor transmittance rate of the adhesive layer was 40 g/m²•day.

Thus, the second barrier layer of three layers of the adhesive layer, the SiN film and the PET film was formed. In addition, the thickness of the PET film on which the SiN was stacked was 50.2 µm including the thickness of the SiN layer, and therefore the total thickness of the second barrier layer was 70.2 µm.

### (Formation of Light Emission Panel)

The light emission panel which each organic EL element was electrically connected with was formed by disposing four elements on the SUS base material in parallel, and crimping the connector members of the connection substrate illustrated in Fig. 8 to the electrode terminals (the anode terminal and the cathode terminal) of each organic EL element.

In addition, the connection substrate was a polyimide film whose substrate had flexibility. That is, a connection substrate was a FPC.

### (Sealing with Sealing Member)

The same SiN stacked PET film (manufactured by Mitsubishi Plastics, Inc., trade name "DIAFOIL") was laminated on the SUS base material to cover the entirety of the four organic EL elements disposed on the SUS base material in parallel. These PET film and SUS base material were adhered using an adhesive whose main component was the same low water content epoxy as that used to form the second barrier layer. That is, the SiN stacked PET film was vacuum-laminated on the entirety of the organic EL elements under the condition that the SiN stacked PET film was heated at 80°C. Subsequently, the adhesive layer was heated at 100°C for two hours, and was cured. The thickness of the adhesive layer was 20 µm.

Thus, the sealing member adopting the two-layer structure including the PET film on which the SiN was stacked and the adhesive layer made of low content water epoxy was laminated on the entirety of the four organic EL elements. A total thickness of the sealing member was 70.2 µm.

In addition, the sealing member was laminated to include the connection portions of the connection substrate (FPC) and the electrode terminals. That is, the light emission region formed by the four surface regions, the inter-layer region sandwiched by the organic layers and the connection portions were sealed by the sealing member.

Thus, the organic EL device according to Example 1 was made by laminating the sealing member to the light emission panel.

### [Example 2]

An organic EL device according to Example 2 was made according to the same method as that in Example 1 except that, instead of a PET film on which SiN was stacked, an EVA film having the thickness of 400 µm was vacuum-laminated as a sealing member under a condition that the EVA film was heated at 100°C, and an adhesive layer was not provided between the EVA film and four organic EL elements.

That is, in Example 2, the sealing member formed only by the EVA film was laminated on the entirety of the four organic EL elements.

In addition, a water vapor transmittance rate of the EVA film was 18 g/m²•day. A total thickness of the sealing member was 400 µm.

### [Example 3]

An organic EL device according to Example 3 was made according to the same method as that in Example 1 except that, instead of a stainless steel plate, a glass plate having the thickness of 700 µm was used as a base material and, instead of the PET film on which SiN was stacked, a glass plate having the thickness of 700 µm was used as a sealing member.

### [Comparative Example 1]

An organic EL device according to Comparative Example 1 was made according to the same method as that in Example 1 except that sealing was not carried out using a sealing member (a PET film on which SiN was stacked).

### (Evaluation of Sealing Property)

Each organic EL device according to Examples 1 to 3 and Comparative Example 1 was put in a temperature and humidity testing chamber (intra-chamber temperature ... 60°C, intra-chamber humidity ... 90%) and was left for 500 hours. Subsequently, by using as a criterion (100%) a light emission area of each organic EL device before each organic EL device was put in the temperature and humidity testing chamber, the degree of decrease in the light emission area of each organic EL light emission area after each organic EL device was put in the temperature and humidity testing chamber was measured. A measurement result is shown in following Table 1.

### (Evaluation of Flexibility)

Each organic EL device according to Examples 1 to 3 and Comparative Example 1 was bent, and whether or not each organic EL device sufficiently bent in terms of practical use was visually checked. A measurement result is shown in following Table 1.

Further, in Table 1, "○" indicates that the organic EL device sufficiently bent in terms of practical use, and "x" indicates that the organic EL device did not bend at all or did not sufficiently bend in terms of practical use.

**[Table 1]**

| | Sealing Member | Base Material | Light Emission Region Left After 500 Hours | Bend |
|---|---|---|---|---|
| Example 1 | PET film on which SiN was stacked | SUS | 98% | ○ |
| | Adhesive layer | | | |
| Example 2 | EVA film | SUS | 90% | ○ |
| Example 3 | Glass plate | Glass plate | 99% | × |
| | Adhesive layer | | | |
| Comparative Example 1 | None | SUS | 75% | ○ |

### INDUSTRIAL APPLICABILITY

An organic EL device of the present invention can be used for displays, and illuminating devices, or the like.

1 Organic EL emitting device, 2 Light emission panel, 21 Base material, 22 Light emission region, 23 Inter-layer region, 3 Sealing member, 31 Sidewall portion, 32 Ceiling portion, 33 Sealing space, 34 First barrier layer, 35 Resin layer, 4 Connector member, 41 Connection circuit, 411 First connection circuit, 412 Second connection circuit, 42 Substrate, 5 Organic EL element, 51 Element substrate, 52 Anode layer, 521 Anode terminal, 53 Organic layer, 54 Cathode layer, 541 Cathode terminal, 55 Second barrier layer, 6 Connection portion. 61 Connector member. 7 Lead wire, 9 External power supply

## Claims

1. An organic electroluminescence device comprising: a light emission panel and a sealing member, wherein
the light emission panel comprises a base material, a plurality of organic electroluminescence elements each including an organic layer and electrode terminals, and a connection portion, wherein the organic electroluminescence elements are disposed on the base material in parallel in a tile pattern, and the connection portion is a portion to which the electrode terminals of each organic electroluminescence element are electrically connected; and
the sealing member seals a light emission region formed by a plurality of organic layers and an inter-layer region sandwiched by two neighboring organic layers in the light emission panel.

2. The organic electroluminescence device according to claim 1, wherein
the electrode terminals include an anode terminal and a cathode terminal, and
the connection portion includes a connector member provided across an anode terminal and a cathode terminal of two neighboring organic electroluminescence elements in the light emission panel.

3. The organic electroluminescence device according to claim 1 or 2. wherein the sealing member inclusively seals the connection portion.

4. The organic electroluminescence device according to claim 2 or 3, wherein the connector member is provided at one side portion of the light emission panel.

5. The organic electroluminescence device according to any one of claims 2 to 4, wherein a connection substrate including the connector member and a substrate on a surface of which the connector member is provided is connected to anode terminals and cathode terminals of the plurality of organic electroluminescence elements in the light emission panel to electrically connect each of the organic electroluminescence elements.

6. The organic electroluminescence device according to claim 5, wherein
the connection substrate further includes a connection circuit which connects the organic electroluminescence elements in the light emission panel, to an external power supply, and
the connection circuit, and an anode terminal and a cathode terminal of organic electroluminescence elements positioned at both ends of the light emission panel are electrically connected.

7. The organic electroluminescence device according to any one of claims 1 to 6, wherein
the sealing member includes a sidewall portion which surrounds at least the light emission region and the inter-layer region, and a ceiling portion which covers the light emission region and the inter-layer region.

8. The organic electroluminescence device according to claim 7, wherein
a sealing space is formed between the sealing member and the light emission panel, and
at least one of a desiccant and an oxygen absorber is filled in the sealing space.

9. The organic electroluminescence device according to any one of claims 1 to 6, wherein
the sealing member is a continuous resin layer which covers without a gap at least the light emission region and the inter-layer region.

10. The organic electroluminescence device according to any one of claims 1 to 9, wherein each organic electroluminescence element in the light emission panel further includes a barrier layer which prevents an outdoor air from entering.

11. An organic electroluminescence device manufacturing method comprising: a light emission panel forming step and a sealing step, wherein
the light emission panel forming step comprises a disposing step of disposing a plurality of organic electroluminescence elements each including an organic layer and electrode terminals, on a base material in parallel in a tile pattern, and a connecting step of electrically connecting the electrode terminals of each organic electroluminescence element to form a connection portion; and
the sealing step is a step of inclusively sealing, using a sealing member, a light emission region formed by a plurality of organic layers, and an inter-layer region sandwiched by two neighboring organic layers in the light emission panel.

12. The organic electroluminescence device manufacturing method according to claim 11, wherein
the electrode terminals include an anode terminal and a cathode terminal, and
the connection step is a step of electrically connecting an anode terminal and a cathode terminal of two neighboring organic electroluminescence elements in the light emission panel using a connector member to form a connection portion.

13. The organic electroluminescence device manufacturing method according to claim 12, wherein the sealing step is a step of further inclusively sealing the connection portion.

14. The organic electroluminescence device manufacturing method according to claim 12 or 13, wherein
the connection step is a step of connecting a connection substrate including the connector member and a substrate on a surface of which the connector member is provided, to anode terminals and cathode terminals of the plurality of organic electroluminescence elements in the light emission panel to electrically connect each of the organic electroluminescence elements and form a connection portion.
